# EUROPÄISCHE PATENTANMELDUNG

(11) **EP 1 684 568 A2**
(43) Veröffentlichungstag der Anmeldung: **26.07.2006**
(21) Anmeldenummer: 05112604.3
(22) Anmeldetag: 21.12.2005
(51) Int. Cl.: H05K 13/04

(54) **Zuführeinrichtung für elektrische Bauelemente**

(30) Priorität: 19.01.2005 DE 102005002566
(71) Anmelder: SIEMENS AKTIENGESELLSCHAFT, 80333 München (DE)
(72) Erfinder: Liebeke, Thomas, 85521, Ottobrunn (DE); Lintner, Albert, 83714, Miesbach (DE)

(57) **Zusammenfassung**

Eine Zuführeinrichtung (1), insbesondere für elektrische Bauelemente (6), mit einem Transportrad (2), welches entlang seines Außenumfangs Stifte (3) aufweist, die in entsprechende Perforationen (7) eines Bauelementegurts (4) eingreifen, um den Bauelementegurt (4) in einer Transportrichtung zu transportieren, und welches in einem Spalt (9) verläuft, der durch zwei sich in Transportrichtung erstreckende Wandabschnitte (10) der Zuführeinrichtung (1) gebildet wird, weist ein Abdeckelement (11) auf, welches den Spalt (9) abdeckt.

## Beschreibung

Die Erfindung bezieht sich auf eine Zuführeinrichtung, insbesondere zum Fördern von Bauelementegurten, die mit elektrischen Bauelementen beladen sind.

Eine derartige Zuführeinrichtung ist aus der Offenlegungsschrift DE 10020748 bekannt. Danach umfasst die Zuführeinrichtung ein Transportrad, welches an seinem Außenumfang Stifte aufweist, die in entsprechende Perforationen des Bauelementegurts, welcher die Bauelemente in taschenartigen Vertiefungen trägt, eingreift. Durch Drehen des Transportrades werden die Bauelemente auf diese Weise sukzessive zu einer Abholposition transportiert, an welcher die Bauelemente beispielsweise durch einen Bestückkopf aufgenommen werden. Das Transportrad läuft in der Regel in einem Spalt, der durch zwei sich in der Transportrichtung des Gurtes erstreckende Wandabschnitte der Zuführeinrichtung gebildet wird. Da das Transportrad meistens nahe der Abholposition der Zuführeinrichtung angeordnet ist, kommt es immer wieder vor, dass die in den taschenartigen Vertiefungen des Bauelementgurtes an dieser Stelle frei liegenden Bauelemente durch die ruckartigen Transportbewegungen oder durch Fehler beim Abholen durch den Bestückkopf in den Spalt, in welchem das Transportrad verläuft, gelangen. Die Bauelemente können sich dann beispielsweise in der Antriebsmechanik des Transportrades verklemmen und dort Schaden anrichten.

Es ist deshalb die Aufgabe der vorliegenden Erfindung, eine Zuführeinrichtung mit einer erhöhten Betriebssicherheit zu liefern.

Die Aufgabe wird durch eine Zuführeinrichtung gemäß dem unabhängigen Anspruch 1 gelöst. Danach weist die Zuführeinrichtung ein Abdeckelement auf, welches den Spalt, in dem das Transportrad verläuft, so abdeckt, dass ein Eindringen von Bauelementen wirksam verhindert wird. Insbesondere beim Transport von sehr kleinen Bauelementen kann somit die Gefahr, dass ein Bauelement durch den Spalt bis in die Antriebsmechanik der Zuführeinrichtung gelangt und dort Schaden bis hin zu einem Stillstand der Zuführeinrichtung anrichten, wirkungsvoll unterbunden werden. Dadurch wird die Betriebssicherheit der Zuführeinrichtung erheblich gesteigert.

Bei einer vorteilhaften Ausgestaltung der Zuführeinrichtung gemäß dem Anspruch 2 ist die Länge des Spaltes, in dem das Transportrad verläuft, kleiner als der Durchmesser des Transportrades. Dies bedeutet, dass der Spalt nur so lange ist, dass ein Bogensegment des Transportrades aus dem Spalt hervorragt, so dass die Stifte des Transportrades mit den Perforationen des Bauelementegurtes in Eingriff gebracht werden können. Durch die Reduzierung der Länge des Spaltes kann auch das Abdeckelement bei gleicher Funktionsfähigkeit entsprechend kurz gestaltet werden.

Die Zuführeinrichtung kann gemäß Anspruch 3 ferner so ausgestaltet sein, dass das Abdeckelement beweglich am Gehäuse der Zuführeinrichtung gelagert ist. Dies erlaubt es dem Bediener den Spalt, in dem das Transportrad verläuft, wahlweise abzudecken oder freizugeben. Hierdurch ergibt sich gerade für Montage- oder Reparaturtätigkeiten eine bessere Zugänglichkeit der abgedeckten Stelle an der Zuführeinrichtung.

Bei der Ausgestaltung gemäß Anspruch 4 weist das Abdeckelement in Transportrichtung einen konkaven Querschnitt auf, sodass die Stifte des Transportrads in dem dadurch gebildeten Hohlraum verlaufen können. Durch die beispielsweise kuppelförmige bzw. dachförmige Ausgestaltung des Abdeckelements werden die Stifte und die Teile des Transportrads, die aus dem Spalt herausragen, von dem Abdeckelement übergriffen und sowohl in vertikaler Richtung als auch seitlich sicher abgedeckt. Dies gewährleistet einen sicheren Schutz vor eindringenden Bauelementen.

Im Folgenden wird ein vorteilhaftes Ausführungsbeispiel der erfindungsgemäßen Zuführeinrichtung anhand der beiliegenden Figuren näher erläutert, wobei:
Fig. 1 eine perspektivische Ansicht eines Ausführungsbeispiels der erfindungsgemäßen Zuführeinrichtung,
Fig. 2 eine seitliche Querschnittsansicht der in Fig. 1 dargestellten Zuführeinrichtung, und
Fig. 3 eine schematische Querschnittsansicht eines Teiles der Zuführeinrichtung aus der Fig. 2 an der Schnittlinie A darstellt.

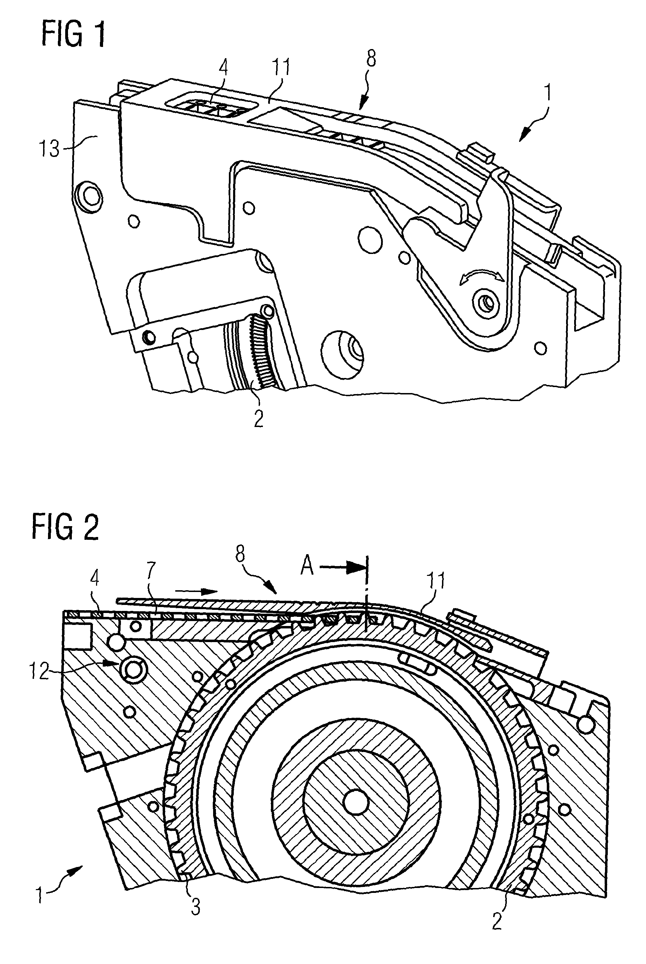

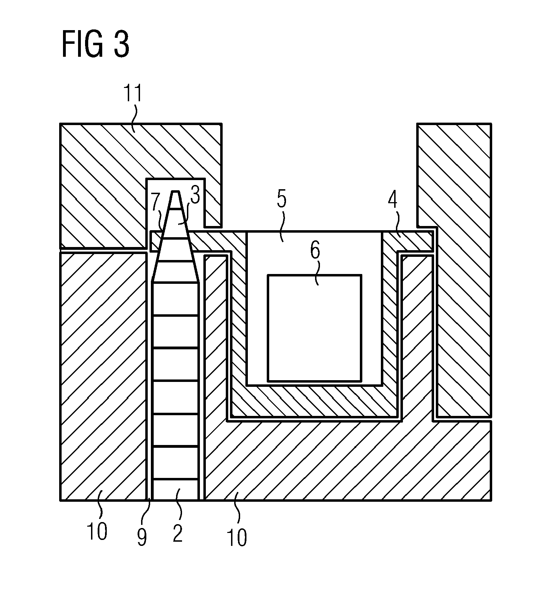

Die Figs. 1 und 2 stellen eine perspektivische Ansicht bzw. eine Querschnittsansicht eines Ausführungsbeispiels der erfindungsgemäßen Zuführeinrichtung dar. Figur 3 zeigt einen schematischen Querschnitt an der Schnittlinie A in Figur 2. Die Zuführeinrichtung 1 weist ein Transportrad 2 auf, an dessen Außenumfang sich radial erstreckende Stifte 3 befinden. Ein Bauelementegurt 4, in dessen taschenartige Vertiefungen 5 elektrische Bauelemente 6 gelagert sind, weist seitlich Perforationen 7 auf, in die die Stifte 3 des Transportrades 2 eingreifen können. Durch Drehen des Transportrades 2 mittels eines (nicht dargestellten) Antriebs werden die Bauelemente 6 in einer (in Fig. 2 durch einen Pfeil dargestellte) Transportrichtung zu einer Abholposition 8 der Zuführeinrichtung 1 transportiert. An der Abholposition 8 werden die elektrischen Bauelemente 6 beispielsweise durch einen Bestückkopf eines Bestückautomaten aufgenommen. Zum Schutz der Bauelemente 6 weist der Bauelementegurt 4 häufig eine Schutzfolie auf, welche die taschenartigen Vertiefungen 5 abdeckt, um ein Herausfallen der Bauelemente 6 zu verhindern. Vor der Abholposition 8 wird diese Abdeckfolie mittels einer (nicht dargestellten) Abziehvorrichtung entfernt, so dass der Bestückkopf die Bauelemente 6 aus den taschenartigen Vertiefungen 5 entnehmen kann. In unmittelbarer Nähe zur Abholposition 8 liegen die Bauelemente 6 daher offen in den Vertiefungen 5 und sind nicht gegen Herausfallen geschützt. Durch die sehr hohen Beschleunigungen des Transportes des Bauelementegurts 4 bei der Zufuhr der Bauelemente 6 kann es immer wieder passieren, dass ein Bauelement 6 ungewollt aus der taschenartigen Vertiefung 5 herausspringt. Genauso kann es passieren, dass es bei einer fehlerhaften Aufnahme des Bauelementes durch den Bestückkopf zu einem Verlust des Bauelementes kommt.

In Fig. 3 ist der Bauelementegurt 4 zu erkennen, in dessen taschenartiger Vertiefung 5 sich ein Bauelement 6 befindet. An einem den Spalt 9 überspannenden seitlichen Fortsatz an einer Oberkante des Bauelementegurtes 4, sind die Perforationen 7 ausgebildet, in die die Stifte 3 des Transportrades 2 eingreifen. Das Transportrad 2 verläuft dabei in einem Spalt 9, welcher durch in der Transportrichtung verlaufende Wandabschnitte 10 der Zuführeinrichtung 1 gebildet wird. Um in die Perforationen 7 des Bauelementegurts 4 eingreifen zu können ragen die Stifte 3 zumindest teilweise aus dem Spalt 9 heraus.

Wie in den Figuren 1, 2 und 3 zu erkennen ist, ist der Spalt 9, in dem das Transportrad 2 verläuft, durch ein an der Zuführeinrichtung 1 vorgesehenes Abdeckelement 11 abgedeckt. Das Abdeckelement 11 weist in Transportrichtung einen konkaven Querschnitt auf, in dessen Hohlraum der aus dem Spalt 9 herausragende Teil der Stifte 3 bzw. des Transportrads 2 verläuft. So kann der Querschnitt des Abdeckelement in Transportrichtung beispielsweise kuppel- bzw. dachförmig ausgebildet sein. Das offene Ende des Querschnitts schließt dabei auf einer Seite mit einem der Wandabschnitte 10 der Zuführeinrichtung 1 und auf der anderen Seite mit dem seitlichen Fortsatz des Bauelementegurts 4 ab. Der horizontale Fortsatz des Bauelementegurts 4 verläuft dabei zwischen dem Abdeckelement 11 und einem der Wandabschnitte 10. Der Spalt 9 wird dadurch sowohl in vertikaler Richtung als auch seitlich abgedeckt, sodass ein Eindringen von den Bauelementen 6 in den Spalt 9 sicher verhindert wird. Dadurch wird die gesamte Antriebsmechanik des Transportrades 2 gut geschützt, wodurch die Betriebssicherheit der Zuführeinrichtung 1 deutlich gesteigert werden kann.

Der Spalt 9 kann dabei in Transportrichtung nur so lange ausgebildet sein, dass zumindest ein Bogensegment des Transportrades 2 aus dem Spalt 9 herausragt, um in die Perforationen 7 des Bauelementegurtes 4 eingreifen zu können. Die Verkürzung der Spaltlänge bringt die Vorteile mit sich, dass erstens die Wahrscheinlichkeit des Eindringens eines Bauelementes 6 von vorne herein gering gehalten werden kann und zweitens die Länge des Abdeckelementes 11 entsprechend klein ausfällt.

Das Abdeckelement 11 ist mittels eines Gelenks 12 beweglich an einem Gehäuse 13 der Zuführeinrichtung 1 angebracht. Dadurch kann das Abdeckelement 11 beispielsweise für Montage- oder Wartungszwecke aufgeklappt werden, um die abgedeckte Stelle freizugeben. Auch ein entsprechender Schiebemechanismus, bei dem das Abdeckelement 11 in einer zur Transportrichtung parallelen Richtung verschoben werden kann, wäre denkbar.

Bezugszeichenliste:
- 1: Zuführeinrichtung
- 2: Transportrad
- 3: Stifte
- 4: Bauelementegurt
- 5: Taschenartige Vertiefung
- 6: Bauelemente
- 7: Perforationen
- 8: Abholposition
- 9: Spalt
- 10: Wandabschnitt
- 11: Abdeckelement
- 12: Gelenk
- 13: Gehäuse

## Patentansprüche

1. Zuführeinrichtung (1), insbesondere für elektrische Bauelemente (6), mit einem Transportrad (2), welches entlang seines Außenumfangs Stifte (3) aufweist, die in entsprechende Perforationen (7) eines Bauelementegurts (4) eingreifen, um den Bauelementegurt (4) in einer Transportrichtung zu transportieren, und welches in einem Spalt (9) verläuft, der durch zwei sich in Transportrichtung erstreckende Wandabschnitte (10) der Zuführeinrichtung (1) gebildet wird, wobei die Zuführeinrichtung (1) ein Abdeckelement (11) aufweist, welches den Spalt (9) abdeckt.

2. Zuführeinrichtung (1) nach Anspruch 1, **dadurch gekennzeichnet, dass** die Länge des Spalts (9) in Transportrichtung kleiner ist als der Durchmesser des Transportrads (2).

3. Zuführeinrichtung (1) nach einem der Ansprüche 1 bis 2, **dadurch gekennzeichnet, dass** das Abdeckelement (11) an einem Gehäuse (13) der Zuführeinrichtung (1) beweglich angebracht ist, um den Spalt (9) wahlweise abzudecken oder freizugeben.

4. Zuführeinrichtung nach einem der Ansprüche 1 bis 3, **dadurch gekennzeichnet, dass** die Stifte (3) zumindest an der Stelle, wo sie in die Perforationen (7) des Bauelementegurts (4) eingreift, zumindest teilweise aus dem Spalt (9) herausragen, und das Abdeckelement (11) in Transportrichtung einen konkaven Querschnitt aufweist, in dessen Hohlraum der aus dem Spalt (9) herausragende Teil der Stifte (3) verläuft.
